# EUROPEAN PATENT APPLICATION

(11) **EP 4 746 598 A1**
(43) Date of publication of application: **20.05.2026**
(21) Application number: 24838589.0
(22) Date of filing: 25.06.2024
(51) Int. Cl.: H05K 5/02

(54) **ELECTRONIC DEVICE AND HOUSING ASSEMBLY**

(30) Priority: 12.07.2023 CN 202310859096
(71) Applicant: Huawei Technologies Co., Ltd., Shenzhen, Guangdong 518129 (CN)
(72) Inventor: YANG, Boxiang, Shenzhen, Guangdong 518129 (CN); LI, Changqing, Shenzhen, Guangdong 518129 (CN); MA, Zhao, Shenzhen, Guangdong 518129 (CN); TENG, Gengchen, Shenzhen, Guangdong 518129 (CN)
(74) Representative: Huawei European IPR
(86) International application number: PCT/CN2024/101361
(87) International publication number: WO 2025/011333

(57) **Abstract**

This application relates to the field of terminal technologies, and discloses an electronic device and a housing assembly. The electronic device includes a housing and a movable decorative module. The movable decorative module is at least partially exposed from an outer wall surface of the housing, and is at least partially movable relative to the housing. When the movable decorative module moves relative to the housing, the movable decorative module can generate an electrical signal for controlling running of the electronic device. In other words, the movable decorative module is movable, and can further generate the electrical signal for controlling running of the electronic device and another electronic device in communication with the electronic device. The electronic device implements a movable design of the decorative module relative to the housing, and enhances tactile experience of a user. In addition, the movable decorative module can further generate the electrical signal, and the electronic device can control, based on the electrical signal, related functions of the electronic device and another electronic device in communication with the electronic device, to integrate tactile experience with function interaction, improve an interactive capability of the electronic device, and enhance user experience.

## Description

This application claims priority to Chinese Patent Application No. 202310859096.6, filed with the China National Intellectual Property Administration on July 12, 2023 and entitled "ELECTRONIC DEVICE AND HOUSING ASSEMBLY", which is incorporated herein by reference in its entirety.

### TECHNICAL FIELD

This application relates to the field of terminal technologies, and in particular, to an electronic device and a housing assembly.

### BACKGROUND

Currently, to implement a specific function and design effect of an electronic device, a mounting hole needs to be disposed on a housing of the electronic device, and a decorative module needs to be disposed at the mounting hole of the housing, to seal and decorate it.

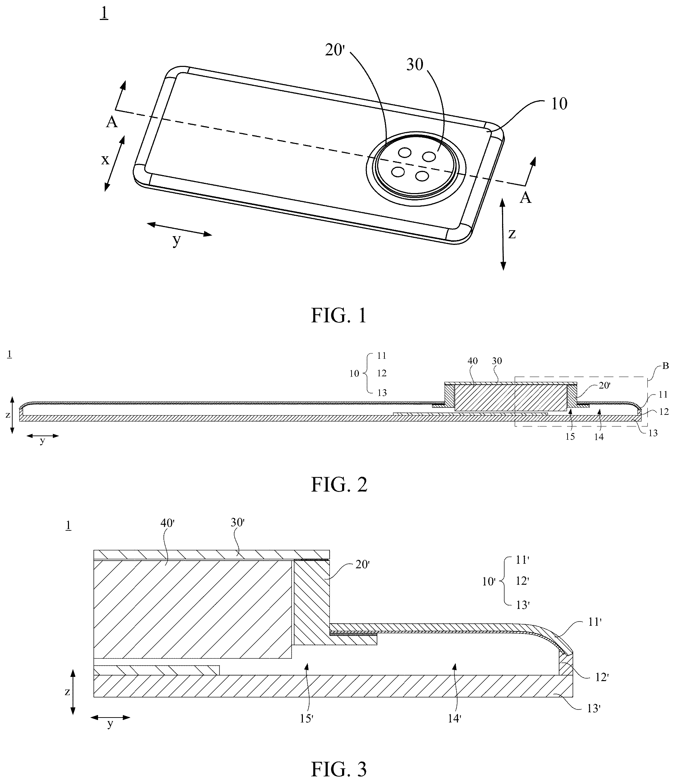

The following uses an example of the electronic device being a mobile phone for description. FIG. 1 is a three-dimensional diagram of a mobile phone 1. FIG. 2 is a sectional view of the mobile phone 1 along line A-A in FIG. 1. FIG. 3 is a partial enlarged view of the mobile phone 1 in a region B in FIG. 2. It can be seen from FIG. 1 to FIG. 3 that the mobile phone 1 includes a housing 10, a decorative module 20, a light-transmitting part 30, and a camera module 40 in some application scenarios. The housing 10 includes a rear housing 11, a middle frame 12, and a display 13. The rear housing 11, the middle frame 12, and the display 13 jointly form a cavity 14. A mounting hole 15 is provided in the rear housing 11. The decorative module 20 is configured to mount the light-transmitting part 30 to the mounting hole 15 of the rear housing 11. The camera module 40 is located in the cavity 14, and is opposite to a position of the light-transmitting part 30. Based on this, the camera module 40 can perform a photographing function through the light-transmitting part 30. The decorative module 20 is integrally sealed to the rear housing 11 in the housing 10.

In the foregoing mobile phone 1, the decorative module 20' enables connectivity and concealment at a junction of the mounting hole 15 of the rear housing 11, achieving both sealing and aesthetic appeal of the mobile phone 1's external design. However, when the mobile phone 1 is in an assembled state, the decorative module 20 cannot move relative to the rear housing 11, leading to a suboptimal interactive capability of an external part of the mobile phone 1, and compromising user experience.

### SUMMARY

In view of this, this application provides an electronic device and a housing assembly. The electronic device includes a housing and a movable decorative module. The movable decorative module is exposed at least partially from an outer wall surface of the housing, and may move at least partially relative to the housing. When the movable decorative module moves relative to the housing, an electrical signal for controlling running of the electronic device can be generated. In other words, the movable decorative module is movable, and can further generate the electrical signal for controlling running of the electronic device and another electronic device in communication with the electronic device. The electronic device implements a movable design of the decorative module relative to the housing, and enhances tactile experience of a user. In addition, the movable decorative module can further generate the electrical signal, and the electronic device can control, based on the electrical signal, related functions of the electronic device and another electronic device in communication with the electronic device, to integrate tactile experience with function interaction, improve an interactive capability of the electronic device, and enhance user experience.

According to a first aspect of this application, an electronic device is provided. The electronic device includes a housing and a movable decorative module. The movable decorative module is exposed at least partially from an outer wall surface of the housing. The movable decorative module may move at least partially relative to the housing, and generate an electrical signal for controlling running of the electronic device. In other words, in an implementation of this application, the movable decorative module is movable relative to the housing, and can further generate the electrical signal for controlling running of the electronic device and another electronic device in communication with the electronic device.

The electronic device in this application includes but is not limited to electronic devices with a housing, such as a mobile phone, a tablet computer, a personal computer, an electronic watch, an electronic wristband, a camera, or a speaker. The housing is a part that is in the electronic device and that is exposed externally. For example, the housing of the mobile phone may include a rear housing (which may also be referred to as a battery cover), a display, and a middle frame.

In the foregoing electronic device, at least some structures of the movable decorative module can move relative to the housing, achieving a movable design of the decorative module relative to the housing, and enhancing tactile experience of a user. In addition, the movable decorative module can further generate the electrical signal, and the electronic device can control, based on the electrical signal, related functions of the electronic device and another electronic device in communication with the electronic device, to integrate tactile experience with function interaction, improve an interactive capability of the electronic device, and enhance user experience.

In some possible implementations of this application, the electronic device can switch a currently selected application, switch currently selected information, and adjust a value of a parameter corresponding to the application based on the electrical signal generated by the movable decorative module. In addition, the electronic device can further adjust, based on the electrical signal generated by the movable decorative module, a parameter of an application of the electronic device or an application of the electronic device in communication with the electronic device.

In some possible implementations of the first aspect, in the electronic device, the housing is provided with a mounting hole that connects the outer wall surface and an inner wall surface, and a fixed decorative component is sealedly connected to the housing around the mounting hole, to seal the mounting hole in the housing. In other words, the housing is provided with the mounting hole, and the mounting hole connects the inner wall surface and the outer wall surface of the housing. The movable decorative module is sealedly mounted on the housing at the mounting hole. The movable decorative module is exposed at least partially from the outer wall surface of the housing through the mounting hole. The movable decorative module may move at least partially relative to the housing, and can generate the electrical signal for controlling running of the electronic device or another electronic device in communication with the electronic device.

In some possible implementations of this application, the housing may alternatively be not provided with the mounting hole, and the movable decorative module is located on the housing and exposed from the outer wall surface of the housing. The movable decorative module may move at least partially relative to the housing, and can generate the electrical signal, where the electrical signal can control running of the electronic device and another electronic device in communication with the electronic device.

In some possible implementations of the first aspect, in the electronic device, the movable decorative module includes a fixed decorative component, a movable decorative component, and a sensing component. The fixed decorative component is mounted on the housing. The movable decorative component is movably mounted on the fixed decorative component. The sensing component generates, based on a motion of the movable decorative component relative to the fixed decorative component, an electrical signal for controlling running of the electronic device. In the foregoing electronic device, the user can implement operability of the movable decorative component relative to the fixed decorative component by operating the movable decorative component, thereby improving the interactive capability of the electronic device and enhancing user experience.

In some possible implementations of this application, at least a part of the movable decorative component is exposed outside the fixed decorative component. In the foregoing electronic device, the user can operate the movable decorative member from the outside of the electronic device. This can reduce difficulty of operating the movable decorative component by the user, and ensure that the movable decorative component is movable relative to the fixed decorative component. In addition, because at least the part of the movable decorative component is exposed outside the fixed decorative component, the user does not need to remove the housing in a process of operating the movable decorative component. This can further ensure sealing performance of the electronic device.

In some possible implementations of this application, the movable decorative component may rotate or move relative to the fixed decorative component. Contours of the movable decorative component and the fixed decorative component may be a circle or a rectangle. This is not specifically limited in this application.

In some possible implementations of the first aspect, in the electronic device, the movable decorative component may include a first movable decorative component. In addition, when the first movable decoration part moves relative to the fixed decorative component, the sensing component generates a first electrical signal for controlling running of the electronic device. In other words, in an implementation of this application, there may be one movable decorative component, and when the movable decorative component moves relative to the fixed decorative component, the sensing component generates the first electrical signal for controlling running of the electronic device.

In some possible implementations of the first aspect, in the electronic device, the movable decorative component may further include a second movable decorative component. In addition, when the second movable decoration part moves relative to the fixed decorative component, the sensing component generates a second electrical signal for controlling running of the electronic device. In other words, in an implementation of this application, there may be a plurality of movable decorative components, and the plurality of movable decorative components may separately move relative to the fixed decorative component. In addition, when the first movable decorative component moves relative to the fixed decorative component, the sensing component generates the first electrical signal for controlling running of the electronic device. When the second movable decorative component moves relative to the fixed decorative component, the sensing component generates the second electrical signal for controlling running of the electronic device. The electronic device, the first electrical signal, the second electrical signal, and a combination thereof may control a solution of running of the electronic device and another electronic device in communication with the electronic device. This allows for diversity of the control solution.

In some possible implementations of this application, the first movable decorative component is sleeved outside the second movable decorative component, and each movable decorative component may move in a same direction or different directions. This can further improve the interactive capability of the electronic device, and further enhance user experience.

In some possible implementations of this application, the first movable decorative component and the second movable decorative component are disposed in parallel, and each movable decorative component may move in a same direction or in different directions. This can further improve the interactive capability of the electronic device, and further enhance user experience.

In some possible implementations of the first aspect, in the electronic device, the sensing component includes a first sensing module and a second sensing module. The first sensing module is located on the movable decorative component. The second sensing module is located on a side that is of the movable decorative component and that is opposite to a side of the fixed decorative component. When the movable decorative component moves relative to the fixed decorative component, the second sensing module senses, based on the first sensing module, the electrical signal for controlling running of the electronic device.

In some implementations of this application, when the first sensing module and the second sensing module are in a preset state, the second sensing module senses a sensing signal based on the first sensing module. In addition, the sensing signal may be used to control another function of the electronic device or the another electronic device in communication with the electronic device.

The first sensing module and the second sensing module being in the preset state may be that the first sensing module and the second sensing module have preset relative positions. In some implementations, the preset relative positions of the first sensing module and the second sensing module may include a relative direction and a relative distance. The relative direction may be a direction from the first sensing module to the second sensing module in a preset coordinate system. The relative distance is an actual distance between the first sensing module and the second sensing module. In this application, the relative direction may be a direction, or may be a direction range. The relative distance may be a distance, or may be a distance range. This is not specifically limited in this application.

In some implementations of this application, the sensing component includes two first sensing modules and a second sensing module. When one of the first sensing modules and the second sensing module are in the preset state, the second sensing module senses the first sensing signal based on the first sensing module. When the other first sensing module and the second sensing module are in the preset state, the second sensing module senses the second sensing signal based on the first sensing module. The first sensing signal and the second sensing signal are used to control another function of the electronic device or the another electronic device in communication with the electronic device.

In some possible implementations of the first aspect, in the electronic device, the first sensing module forms a magnetic field with a circumferential gradient distribution of magnetic field strengths around a central axis. When the movable decorative component moves relative to the fixed decorative component, the second sensing module senses a magnetic field strength change of the magnetic field to generate a sensing signal. In the foregoing electronic device, the sensing component has a simple principle, a simple structure, and relatively low design difficulty.

In some possible implementations of the first aspect, in the electronic device, the first sensing module includes at least two magnet structures that are sequentially arranged in a circumferential direction around the central axis, and magnetic poles of each magnet structure point to a consistent circumferential direction around the central axis. In addition, magnetic strengths of the at least two magnet structures are in a circumferential gradient distribution around the central axis. The second sensing module is a magnetometer.

In other words, in an implementation of this application, the magnetometer senses a direction of a magnetic line of force and a magnetic field strength change, to generate a magnetic signal, and can convert the magnetic signal into an electrical signal. In addition, the magnetometer identifies clockwise rotation or counterclockwise rotation by detecting a direction change of the magnetic line of force during the rotation, to convert the magnetic signal into the electrical signal.

In some possible implementations of the first aspect, in the electronic device, the first sensing module has a surface with a circumferential gradient distribution of surface roughnesses around the central axis. When the movable decorative component moves relative to the fixed decorative component, the second sensing module senses a surface roughness change of the surface to generate a sensing signal. In the foregoing electronic device, the sensing component has a simple structure and relatively low design difficulty, allowing for an optimized layout solution of the electronic device.

In some possible implementations of the first aspect, in the electronic device, the first sensing module includes a grating that is arranged in the circumferential direction around the central axis. Surface roughnesses of the grating are in a circumferential gradient distribution around the central axis. The second sensing module is an optoelectronic element. In other words, the grating has a surface with a circumferential gradient distribution of surface roughnesses around the central axis. When the movable decorative component moves relative to the fixed decorative component, the photoelectric element senses a surface roughness change of the surface to generate a sensing signal. In other words, when the movable decorative component rotates relative to the fixed decorative component, the photoelectric element emits a beam of light and measures a phase and an amplitude of the reflected light, so as to measure a surface height difference. This helps determine a relative position of the movable decorative component after the movable decorative component rotates relative to the fixed decorative component, and further adjust a signal sensed by the sensing component.

It may be understood that the first sensing module and the second sensing module are merely some implementations. Other implementations of the first sensing module and the second sensing module that can determine different sensing signals based on different relative positions are also within the protection scope of this application. This is not specifically limited in this application.

In some possible implementations of the first aspect, in the electronic device, a manner of sealedly connecting the decorative component to the housing includes at least one of the following: sealedly connecting the decorative component to a surface around the mounting hole on a first side of the housing; or sealedly connecting the fixed decorative component to a surface around the mounting hole on a second side of the housing; or sealedly connecting the fixed decorative component to a surface of the mounting hole on the housing. In the foregoing electronic device, there are various manners of sealedly connecting the fixed decorative component to the housing, thereby expanding an application scope of the technical solutions of this application.

In some possible implementations of the first aspect, in the electronic device, the mounting hole is a circular hole, and the movable decorative component is rotatively connected to the fixed decorative component around a central axis of the mounting hole.

In some possible implementations of the first aspect, in the electronic device, the electronic device further includes a light-transmitting part, and the light-transmitting part is in a circular shape. The fixed decorative component is of an annular structure. A port at one end of the fixed decorative component is sealedly connected to an outer periphery of the light-transmitting part, and a port at the other end is sealedly connected to a housing around the mounting hole. In the foregoing electronic device, the light-transmitting part is disposed, so that light can be transmitted inside and outside the housing while ensuring that the housing is relatively sealed.

In some possible implementations of the first aspect, in the electronic device, the movable decorative component is of an annular structure, and the movable decorative component is sleeved between two ends of the fixed decorative component. In the foregoing electronic device, the movable decorative component and the fixed decorative component have a reasonable structure design, a simple assembly manner, and relatively high stability after assembly.

In some possible implementations of the first aspect, the electronic device further includes a control module. The control module is signal-connected to the movable decorative module, and can generate a control signal based on the electrical signal generated by the movable decorative module. In the foregoing electronic device, after receiving the electrical signal, the control module generates the control signal (for example, an application switching instruction or a volume adjustment instruction) based on control logic and processing logic inherent in the control module.

In some possible implementations of the first aspect, in the electronic device, the electronic device further includes a functional module and a display module. The functional module can generate a display signal based on the control signal generated by the control module. The display module is signal-connected to the functional module. The display module performs display based on the display signal generated by the functional module, to change display effect of the electronic device.

In some possible implementations of the first aspect, in the electronic device, the housing includes at least one of the display, the middle frame, and the rear housing.

In some possible implementations of the first aspect, in the electronic device, the movable decorative component protrudes at least partially from the outer wall surface of the housing. In the foregoing electronic device, the user can operate the movable decorative component from the outside of the electronic device, reducing difficulty of operating the movable decorative component by the user, and ensuring that the movable decorative component is movable relative to the fixed decorative component. This can improve the interactive capability of the electronic device and enhance experience of operating the movable decorative component by the user. In addition, because the user does not need to remove the housing in a process of operating the movable decorative component, sealing performance of the electronic device can be further ensured.

In some implementations of this application, the movable decorative component is at least partially flush with the outer wall surface of the housing. The electronic device can reduce difficulty of operating the movable decorative component by the user, and enhance experience of operating the movable decorative component by the user. Moreover, a thickness size of the electronic device can be further reduced, allowing for slim and lightweight designs.

According to a second aspect of this application, a housing assembly is provided. The housing assembly includes a housing and a movable decorative module. The movable decorative module is exposed at least partially from an outer wall surface of the housing. The movable decorative module may move at least partially relative to the outer wall surface of the housing, and generate an electrical signal for controlling running of the electronic device.

### BRIEF DESCRIPTION OF DRAWINGS

To describe technical solutions of this application more clearly, the following briefly describes accompanying drawings used in describing implementations.
FIG. 1 is a three-dimensional diagram of a mobile phone 1;
FIG. 2 is a sectional view of the mobile phone 1 along line A-A in FIG. 1;
FIG. 3 is a partial enlarged view of the mobile phone 1 in a region B in FIG. 2;
FIG. 4 is a partial enlarged view of the region B in FIG. 2 according to some embodiments of this application;
FIG. 5 is an exploded view of the mobile phone 1 according to some embodiments of this application;
FIG. 6 is a three-dimensional diagram of the mobile phone 1 according to some embodiments of this application;
FIG. 7 is a sectional view of the mobile phone 1 along line C-C in FIG. 6 according to some embodiments of this application;
FIG. 8 is a partial enlarged view of a region D in FIG. 7 according to some embodiments of this application;
FIG. 9(a) shows a relative position relationship among a movable decorative component 200, a light-transmitting part 30, and a camera module 40 according to some embodiments of this application;
FIG. 9(b) shows a relative position relationship among the movable decorative component 200, the light-transmitting part 30, and the camera module 40 according to some other embodiments of this application;
FIG. 9(c) shows a relative position relationship among the movable decorative component 200, the light-transmitting part 30, and the camera module 40 according to some other embodiments of this application;
FIG. 9(d) shows a relative position relationship among the movable decorative component 200, the light-transmitting part 30, and the camera module 40 according to still some other embodiments of this application;
FIG. 9(e) shows a relative position relationship among the movable decorative component 200, the light-transmitting part 30, and the camera module 40 according to yet some other embodiments of this application;
FIG. 10 is a diagram of the fixed decorative component 100, a rear housing 11, the light-transmitting part 30, and the camera module 40 according to some embodiments of this application;
FIG. 11(a) is a partial enlarged view of a region E in FIG. 10 according to some other embodiments of this application;
FIG. 11(b) is a partial enlarged view of a region E in FIG. 10 according to some other embodiments of this application;
FIG. 12 is a diagram of the movable decorative component 200 in FIG. 9 according to some embodiments of this application;
FIG. 13 is a partial enlarged view of a region D in FIG. 7 according to some other embodiments of this application;
FIG. 14(a) is a modular diagram of the mobile phone 1 according to some embodiments of this application;
FIG. 14(b) is a modular diagram of the mobile phone 1 according to some embodiments of this application;
FIG. 15(a) to FIG. 15(c) are diagrams of interface changes of the mobile phone 1 according to some embodiments of this application;
FIG. 16(a) to FIG. 16(c) are diagrams of interface changes of the mobile phone 1 according to some other embodiments of this application;
FIG. 17(a) and FIG. 17(b) are diagrams of an operating principle of a first sensing module 310 and a second sensing module 320 according to some embodiments of this application;
FIG. 18(a) is a diagram of a relative position relationship between the first sensing module 310 and the second sensing module 320 according to some embodiments of this application;
FIG. 18(b) is a diagram of a relative location relationship between the first sensing module 310 and the second sensing module 320 according to some other embodiments of this application;
FIG. 19(a) and FIG. 19(b) are diagrams of a structure of the first sensing module 310 according to some embodiments of this application;
FIG. 20 is a diagram of a structure of a sensing assembly 300 according to some embodiments of this application;
FIG. 21 is a diagram of a structure of a sensing assembly 300 according to some embodiments of this application;
FIG. 22 is a diagram of a first decorative part 110 and the movable decorative component 200 according to some embodiments of this application; and
FIG. 23 is a partial enlarged view of a region F in FIG. 22.

Reference numerals of the accompanying drawings: 10-housing; 11-rear housing; 12-middle frame; 13-display; 14-cavity; 15-mounting hole; 20-movable decorative module; 100-fixed decorative component; 110-first decorative part; 120-second decorative part; 200-movable decorative component; 300-sensing assembly; 310-first sensing module; 320-first sensing module; 30-lens; 40-lens module; 50-adhesive; 60-control module; 70-functional module; 80-display module; and 90-rectifier module.

### DESCRIPTION OF EMBODIMENTS

The following further describes technical solutions of this application in detail with reference to accompanying drawings.

The technical solutions provided in this application are applicable to electronic devices. The electronic devices include but are not limited to electronic devices having a housing, such as mobile phones, tablet computers, personal computers, electronic watches, electronic wristbands, cameras, or speakers. This is not specifically limited in this application. The housing is a component that is exposed outside the electronic device. For example, the housing of the mobile phone may include a rear housing (also referred to as a battery cover), a display, and a middle frame. For ease of understanding and description, the following continues to describe the solution involving the rear housing of the mobile phone and the decorative camera module mounted on the rear housing.

For ease of description, before specific structures of the mobile phone are described, an x-axis, a y-axis, and a z-axis corresponding to the mobile phone are first defined. For example, the mobile phone is in its normal placement. The positive x-axis runs from a left edge of the mobile phone to a right edge of the mobile phone. The positive y-axis runs from a bottom edge of the mobile phone (for example, an end where a charging port of the mobile phone is located) to a top edge of the mobile phone (for example, an end where a camera of the mobile phone is located). The positive z-axis is defined along a thickness direction of the mobile phone. The x axis, the y axis, and the z axis intersect each other. In addition, the xoy plane is defined as a projection plane. In some embodiments of this application, the x axis, the y axis, and the z axis are perpendicular to each other. In addition, a direction from the rear housing to a display along the z-axis is defined as a first direction. In this application, a thickness of a component is a size in the z-axis direction. Details are not described below. Finally, in this application, outside denotes a direction from an inner component (or space) toward an outer component (or space), whereas inside denotes a direction from an outer component (or space) toward an inner component (or space). In addition, that a first component is exposed outside a second component may mean that the first component is visible when viewed from the outside, meaning that the second component does not fully shield the first component.

To resolve the problem described in the Background, this application provides a mobile phone. In the mobile phone, a decorative module is a movable decorative module. The movable decorative module is at least partially exposed from the outer wall surface of a housing, and is at least partially movable relative to the housing. The movable decorative module can generate an electrical signal for controlling running of the mobile phone and another electronic device in communication with the mobile phone. Based on this, the movable decorative module is moveable relative to the housing, and also generate the electrical signal for controlling running of the mobile phone and the another electronic device in communication with the mobile phone.

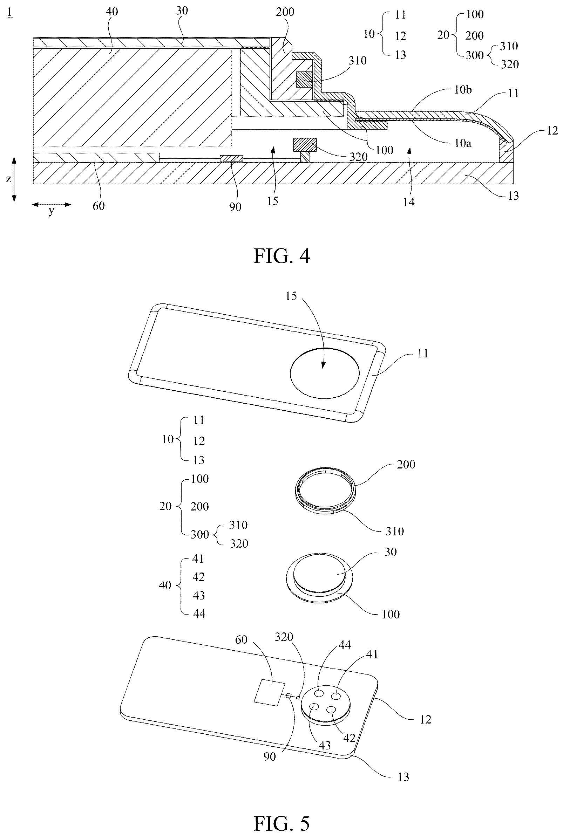

The following provides descriptions with reference to the accompanying drawings. FIG. 4 is a partial enlarged view of a region B in FIG. 2 according to some embodiments of this application.

As shown in FIG. 4, in some embodiments of this application, a mobile phone 1 includes a rear housing 11 and a movable decorative module 20. The rear housing 11 has an inner wall surface 11a and an outer wall surface 11b that are disposed opposite to each other. The rear housing 11 is provided with a mounting hole 15, and the mounting hole 15 connects the inner wall surface 11a and the outer wall surface 11b of the rear housing 11. The movable decorative module 20 is sealedly mounted on the rear housing 11 at the mounting hole 15. The movable decorative module 20 is at least partially exposed, through the mounting hole 15, from the outer wall surface 11b of the rear housing 11 of the housing 10. The movable decorative module 20 at least partially moves relative to the housing 10, and the movable decorative module 20 can generate an electrical signal for controlling running of the mobile phone 1 or another electronic device.

It may be understood that the electrical signal may be understood as a trigger signal, which is a signal generated by the movable decorative module 20 and used to trigger the operating of the mobile phone 1 or the another electronic device in communication with the mobile phone 1. The control module in the mobile phone 1 can generate a control signal based on the trigger signal, to instruct a corresponding module in the mobile phone 1 to control running of the mobile phone 1 or the another electronic device in communication with the mobile phone 1 based on the control signal.

In the mobile phone 1, at least a portion of the structure of the movable decorative module 20 is movable relative to the housing 10, thereby implementing a movable design of the decorative module relative to the housing, and enhancing user's tactile experience. In addition, the movable decorative module 20 can further generate the electrical signal, and the mobile phone 1 can control related functions of the mobile phone 1 and the another electronic device in communication with the mobile phone 1 based on the electrical signal, thereby integrating tactile experience with function interaction, improving an interactive capability of the mobile phone 1, and enhancing user experience.

In some embodiments of this application, based on the electrical signal generated by the movable decorative module 20, the mobile phone 1 can switch a currently selected application, switch currently selected information, and adjust magnitude of parameters corresponding to the application. In addition, the mobile phone 1 can further adjust applications or parameters of the applications of the electronic devices in communication with the mobile phone 1 based on the electrical signal generated by the movable decorative module 20.

In some other embodiments of this application, the rear housing 11 may not be provided with a mounting hole, and the movable decorative module 20 is located on the rear housing 11 and exposed from the outer wall surface 11b of the rear housing 11. The movable decorative module 20 is at least partially movable relative to the rear housing 11, and the movable decorative module 20 can generate the electrical signal, where the electrical signal can control running of the mobile phone 1 and the another electronic device in communication with the mobile phone 1.

In some embodiments of this application, there may be a plurality of movable decorative components 200, and the plurality of movable decorative components 200 may move individually relative to the fixed decorative component 100.

To better understand the technical solutions of this application, the following describes in detail, with reference to the accompanying drawings, the mobile phone 1 to which the technical solutions of this application are applicable.

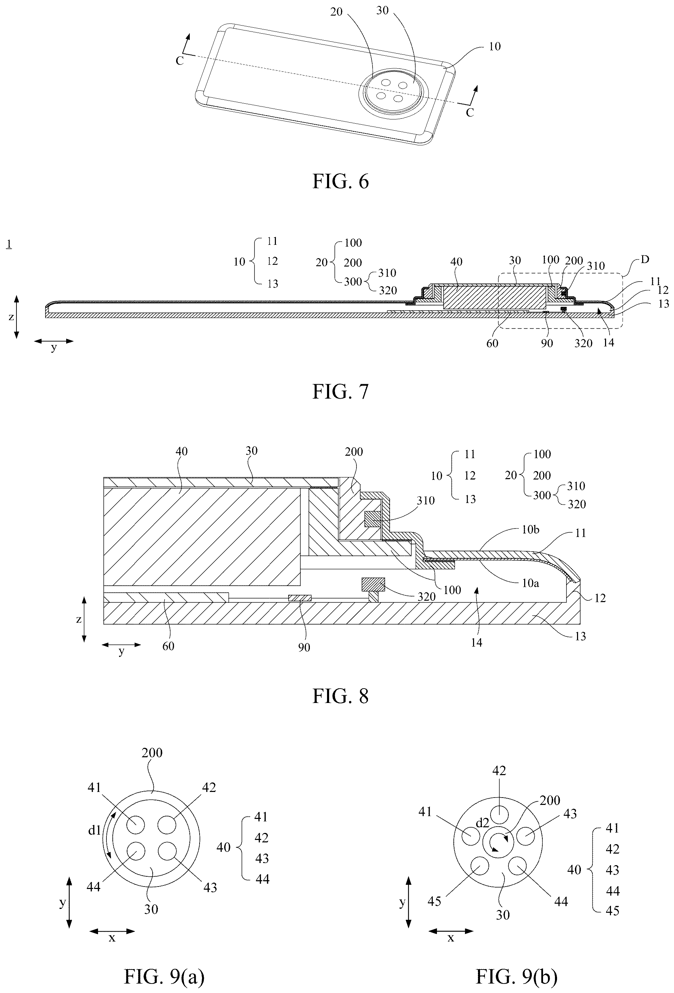

FIG. 5 is an exploded view of the mobile phone 1 according to some embodiments of this application. FIG. 6 is a three-dimensional diagram of the mobile phone 1 according to some embodiments of this application. FIG. 7 is a sectional view of the mobile phone 1 along line C-C in FIG. 6 according to some embodiments of this application. FIG. 8 is a partial enlarged view of a region D in FIG. 7 according to some embodiments of this application.

With reference to FIG. 5 to FIG. 8, it is not difficult to find that in some embodiments of this application, the mobile phone 1 includes the housing 10, the movable decorative module 20, a light-transmitting part 30, and a camera module 40. The housing 10 includes a rear housing 11, a middle frame 12, and a display 13. The rear housing 11, the middle frame 12, and the display 13 jointly define a cavity 14. A mounting hole 15 is disposed in the rear housing 11, and the mounting hole 15 connects the cavity 14 and the exterior of the mobile phone 1. The movable decorative module 20 includes a fixed decorative component 100 and a movable decorative component 200. The camera module 40 includes several cameras. For example, the camera module 40 includes a first camera 41, a second camera 42, a third camera 43, and a fourth camera 44.

The light-transmitting part 30 is sealedly mounted around the mounting hole 15 in the rear housing 11 by using the fixed decorative component 100. The camera module 40 is located in the cavity 14, and is disposed within the cavity 14. The mounting hole 15 in the rear housing 11, the light-transmitting part 30, and the camera module 40 are located opposite to each other. The light-transmitting part 30 is matched to the camera module 40, allowing the camera module 40 to receive, via the light-transmitting part 30, light reflected by external scenes of the mobile phone 1, so as to achieve a photographing function. The movable decorative component 200 is movably connected to the fixed decorative component 100, and the movable decorative component 200 is at least partially exposed outside the fixed decorative component 100. It may be understood that, in this application, relative positions of one component and another component may be such that, when the component and the another component are projected onto a specific projection plane along a direction, a projection area of the component and a projection region of the another component basically overlap, or the projection region of the component is located within the projection area of the another component, or the projection area of the another component is located within the projection area of the component.

In this application, in an assembled state of the mobile phone 1, the light-transmitting part 30, the movable decorative module 20, the rear housing 11, the middle frame 12, and the display 13 jointly define a sealed cavity 14, such that the movable decorative module 20 is sealed with the rear housing 11, and the movable decorative module 20 is sealed with the light-transmitting part 30. Further, after the rear housing 11 is mounted to the middle frame 12 and the display 13, sealing performance of the interior of the mobile phone 1 can be ensured, thereby preventing liquid, dust, and the like from entering the interior of the mobile phone 1, and preserving operational performance and a service life of the mobile phone 1. In addition, the fixed decorative component 100 is mounted on the rear housing 11 and immovable relative to the rear housing 11, whereas the movable decorative component 200 is mounted on the fixed decorative component 100 and movable relative to the fixed decorative component 100 (namely, the rear housing 11). The movable decorative component 200 is at least partially exposed outside the fixed decorative component 100. The foregoing design enables users to operate the movable decorative component 200 from the outside, thereby allowing the movable decorative component 200 to move relative to the fixed decorative component 100, and improving the interactive capability of the mobile phone 1, and enhancing user experience.

Still refer to FIG. 5 to FIG. 8. In some embodiments of this application, the light-transmitting part 30 is sealedly connected to the fixed decorative component 100, an outer periphery of the fixed decorative component 100 is sealedly mounted around the mounting hole 15 in the rear housing 11, and the rear housing 11 is sealedly connected to the middle frame 12. The rear housing 11 is sealedly mounted to the middle frame 12, and the middle frame 12 is sealedly mounted to the display 13. Based on this, the light-transmitting part 30, the fixed decorative component 100, the rear housing 11, the middle frame 12, and the display 13 jointly define the sealed cavity 14.

In some embodiments of this application, the movable decorative module 20 passes through the mounting hole 15 in the rear housing 11 and protrudes from an outer wall surface of the rear housing 11. In addition, the portion of the movable decorative module 20 that protrudes from the outer wall surface of the rear housing 11 includes the movable decorative component 200. In other words, the movable decorative component 200 is movably connected to the fixed decorative component 100, the movable decorative component 200 is at least partially exposed outside the fixed decorative component 100, and the portion of the movable decorative component 200 that is exposed outside the fixed decorative component 100 is exposed outside the rear housing 11, such that the movable decorative component 200 can be exposed from the outer wall surface 11b of the rear housing 11. In this way, users can operate the movable decorative component 200 from the outside of the mobile phone 1, thereby reducing difficulty of operating the movable decorative component 200, implementing movability of the movable decorative component 200 relative to the fixed decorative component 100 (namely, the rear housing 11 or the rear housing 10), increasing the interactive capability of the mobile phone 1, and enhancing user experience of operating the movable decorative component 200. In addition, because the user does not need to remove the rear housing 11 in a process of operating the movable decorative component 200, sealing performance of the mobile phone 1 can be further ensured.

In some embodiments of this application, the movable decorative module 20 passes through the mounting hole 15 in the rear housing 11 and is flush with the outer wall surface 11b of the rear housing 11. In addition, the portion that is of the movable decorative module 20 and that is flush with the outer wall surface 11b of the rear housing 11 includes the movable decorative component 200. That is, the movable decorative component 200 is movably connected to the fixed decorative component 100, the movable decorative component 200 is at least partially exposed outside the fixed decorative component 100, and a portion of the movable decorative component 200 exposed outside the fixed decorative component 100 is flush with the outer wall surface 11b of the rear housing 11, such that the movable decorative component 200 can be exposed from the outer wall surface 11b of the rear housing 11. In this way, difficulty of operating the movable decorative component 200 by users can be reduced, and user experience of operating the movable decorative component 200 can be improved. In addition, a thickness of the mobile phone 1 can be reduced, thereby achieving compact designing of the mobile phone 1.

In some embodiments of this application, an outer periphery of the fixed decorative component 100 is in close contact with the inner wall surface 11a of the rear housing 11. Alternatively, the outer periphery of the fixed decorative component 100 is in close contact with the outer wall surface 11b of the rear housing 11. Alternatively, the outer periphery of the fixed decorative component 100 is in close contact with a surface of the mounting hole 15 in the rear housing 11. It can be understood that there are various connection manners between the fixed decorative component 100 and the rear housing 11 in the mobile phone 1, and the foregoing arrangement may be split and recombined as required. This is not specifically limited in this application.

In some embodiments of this application, the movable decorative module 20 further includes a sensing assembly 300. The sensing assembly 300 can generate, based on motion of the movable decorative component 200 relative to the fixed decorative component 100, the electrical signal for controlling running of the mobile phone 1 or the another electronic device in communication with the mobile phone 1. It may be understood that the electrical signal generated by the sensing assembly 300 may be a direct current electrical signal or an alternating current electrical signal. This is not specifically limited in this application.

In some embodiments of this application, the sensing assembly 300 includes a first sensing module 310 and a second sensing module 320. The first sensing module 310 is mounted on the movable decorative component 200, and the second sensing module 320 is located in the cavity 14 and mounted on a main body 400. When the first sensing module 310 and the second sensing module 320 are in a preset state, the second sensing module 320 and the first sensing module 310 sense a sensing signal, and convert the sensed sensing signal into an electrical signal for output. In addition, the sensing signal may be used to control another function of the mobile phone 1 or the another electronic device in communication with the mobile phone 1. The sensing signal may be a magnetic signal or an electrical signal. This is not specifically limited in this application.

In some implementations, the second sensing module 320 generates a first sensing signal based on the first sensing module 310. In some other alternative implementations, the first sensing module 310 generates a second sensing signal based on the second sensing module 320. The first sensing signal and/or the second sensing signal may be used as the sensing signal in this application. This is not specifically limited in this application. For ease of description, the following uses an example in which the second sensing module 320 generates the sensing signal based on the first sensing module 310.

When the mobile phone 1 is in an assembled state, the movable decorative component 200 may move relative to the fixed decorative component 100. When the movable decorative component 200 moves relative to the fixed decorative component 100, a relative position between the first sensing module 310 and the second sensing module 320 in the sensing assembly 300 changes, and the second sensing module 320 generates the sensing signal based on the first sensing module 310.

In some embodiments of this application, there may be a plurality of first sensing modules 310 and a plurality of second sensing modules 320 in the sensing assembly 300.

As shown in FIG. 8, in some embodiments of this application, a rear housing 11 includes an explosion-proof layer 220 and a glass layer 230, where the glass layer 230 is disposed on an inner side of the explosion-proof layer 220.

In some embodiments of this application, in the movable decorative module 20, a quantity of the fixed decorative components 100 is equal to a quantity of the movable decorative components 200, and the fixed decorative components 100 and the movable decorative components 200 are paired.

In some embodiments of this application, the movable decorative component 200 is rotatably connected to the fixed decorative component 100. In other words, the movable decorative component 200 can physically rotate relative to the fixed decorative component 100. In the mobile phone 1, after the movable decorative component 200 moves relative to the fixed decorative component 100, the fixed decorative component 100 and the movable decorative component 200 can be compactly disposed, thereby enabling a compact design of the mobile phone 1 and improving space utilization efficiency.

In some other embodiments of this application, the movable decorative component 200 is slidably connected to the fixed decorative component 100. In other words, the movable decorative component 200 can physically move relative to the fixed decorative component 100. In the mobile phone 1, the movable decorative component 200 moves relative to the fixed decorative component 100, thereby alleviating constraints on outer contours of the fixed decorative component 100 and the movable decorative component 200, and broadening the applicability of technical solutions of this application.

The foregoing implementations are merely several implementations of the fixed decorative component 100 and the movable decorative component 200. Other movement and connection mechanisms of the fixed decorative component 100 and the movable decorative component 200, such as a mechanism where the movable decorative component 200 can both rotate relative to the fixed decorative component 100 and slide relative to the fixed decorative component 100, also fall within the protection scope of this application. This is not specifically limited in this application. For ease of description, the following uses an example in which the movable decorative component 200 is rotatably connected to the fixed decorative component 100.

It can be learned from the foregoing that the movable decorative module 20 in this application includes the fixed decorative component 100 and the movable decorative component 200 that are movably connected. The fixed decorative component 100 is sealedly mounted on the rear housing 11, and the movable decorative component 200 is movably mounted on the fixed decorative component 100. Based on this, the movable decorative component 200 is a user-operable component. The following describes in detail several movable decorative components 200 in the mobile phone 1 with reference to the accompanying drawings.

FIG. 9(a) shows a relative position relationship between the movable decorative component 200, the light-transmitting part 30, and the camera module 40 according to some embodiments of this application. It can be seen from FIG. 5 and FIG. 9(a) that, in some embodiments of this application, the mounting hole 15 on the rear housing 11 is a round hole, the light-transmitting part 30 is a round plate structure, and the movable decorative module 20 is an annular structure that is adapted to the mounting hole 15 on the rear housing 11 and the light-transmitting part 30. Based on this, the movable decorative component 200 in the movable decorative module 20 is an annular structure surrounding the light-transmitting part 30 and the camera module 40.

In some embodiments of this application, a central axis of the movable decorative component 200, a central axis of the mounting hole 15, and a central axis of the light-transmitting part 30 coincide. For ease of description and understanding, in this application, the central axis of the movable decorative component 200, the central axis of the mounting hole 15, and the central axis of the light-transmitting part 30 that coincide are defined as a first preset axis. It may be understood that, in this application, coincidence of two axes is not limited to absolute coincidence. Coincidence of two axes may mean that the two axes are completely coincident, or that the two axes are substantially coincident. The two axes being substantially coincident may mean that the two axes are parallel to each other, and a spacing between the two parallel axes is small. It may alternatively mean that the two axes intersect with a small included angle between the two axes, for example, 0.1°, 0.3°, 0.5°, 1°, or the like.

In some embodiments of this application, the movable decorative component 200 may rotate around the first preset axis in a direction d1 relative to the fixed decorative component 100 (the rear housing 11, the middle frame 12, the display 13, the light-transmitting part 30, and the camera module 40).

In some other embodiments of this application, the movable decorative component 200 may move relative to the fixed decorative component 100 (the rear housing 11, the light-transmitting part 30, the main body 400, and the camera module 40) in a direction parallel to the first preset axis.

In addition, as shown in FIG. 9(a), in some embodiments of this application, the camera module 40 includes at least two cameras. For example, the camera module 40 includes cameras 41, 42, 43, and 44 that are arranged in an array, where the camera module 40 functions as a whole and corresponds to one light-transmitting part 30 and one movable decorative module 20. One light-transmitting part 30 covers the at least two cameras that function as a whole, and one movable decorative module 20 surrounds the at least two cameras that function as a whole.

FIG. 9(b) shows a relative position relationship between the movable decorative component 200, the light-transmitting part 30, and the camera module 40 in some other embodiments of this application. It is easy to find, by comparing FIG. 9(b) with FIG. 9(a), that in some other embodiments of this application, the mounting hole 15 on the rear housing 11 is a round hole, the light-transmitting part 30 is an annular structure, and the movable decorative module 20 is a circular structure. In addition, an outer periphery of the movable decorative module 20 is adapted to an inner periphery of the light-transmitting part 30, and an outer periphery of the light-transmitting part 30 is adapted to the mounting hole on the rear housing 11. Based on this, the movable decorative component 200 in the movable decorative module 20 is a circular structure positioned in the interior of the light-transmitting part 30 and the camera module 40.

It may be understood that the movable decorative component 200 in FIG. 9(b) corresponds to an inner contour of the camera module 40, and is unrelated to an outer contour of the camera module 40. Therefore, a specific form of the camera module 40 may not be limited in embodiments of this application. For example, the outer contour of the camera module 40 may be circular, or may be rectangular. This is not specifically limited in this application.

In some embodiments of this application, the central axis of the movable decorative component 200, the central axis of the mounting hole 15, and the central axis of the light-transmitting part 30 coincide. For ease of description and understanding, in this application, the central axis of the movable decorative component 200, the central axis of the mounting hole 15, and the central axis of the light-transmitting part 30 that coincide are defined as a second preset axis.

In some embodiments of this application, the movable decorative component 200 may rotate around the second preset axis in a direction d2 relative to the fixed decorative component 100 (the rear housing 11, the middle frame 12, the display 13, the light-transmitting part 30, and the camera module 40).

In some other embodiments of this application, the movable decorative component 200 may move relative to the fixed decorative component 100 (the rear housing 11, the middle frame 12, the display 13, the light-transmitting part 30, and the camera module 40) in a direction parallel to the second preset axis.

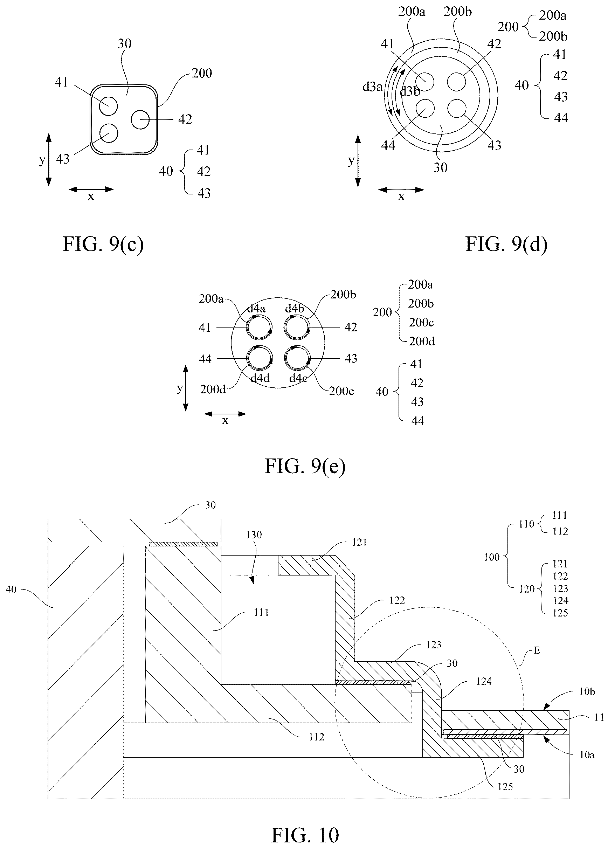

FIG. 9(c) shows a relative position relationship between the movable decorative component 200, the light-transmitting part 30, and the camera module 40 in some further embodiments of this application. It is easy to find, by comparing FIG. 9(c) with FIG. 9(a), that in some embodiments of this application, the mounting hole on the rear housing 11 is a square hole, the light-transmitting part 30 is a square structure, and the movable decorative module 20 is an annular structure that is adapted to the mounting hole on the rear housing 11 and the light-transmitting part 30. Based on this, the movable decorative component 200 in the movable decorative module 20 is an annular structure surrounding the light-transmitting part 30 and the camera module 40.

It may be understood that a square, a square hole, a square sheet, a rectangle, a rectangular hole, a rectangular plate, and the like in this application may be a structure with sharp corners where two sides intersect at a 90° angle, or may be a structure with rounded corners where transitions between two sides are rounded. Such variations will not be repeatedly described in the following.

For ease of description and understanding, in this application, a central axis of a camera in the camera module is defined as a third preset axis. In some other embodiments of this application, the movable decorative component 200 may move relative to the fixed decorative component 100 (the rear housing 11, the middle frame 12, the display 13, the light-transmitting part 30, and the camera module 40) in a direction parallel to the third preset axis.

FIG. 9(d) shows a relative position relationship between the movable decorative component 200, the light-transmitting part 30, and the camera module 40 in some further embodiments of this application. It is easy to find, by comparing FIG. 9(d) with FIG. 9(a), that in some embodiments of this application, the mounting hole 15 on the rear housing 11 is a round hole, the light-transmitting part 30 is a circular structure, and the movable decorative module 20 is an annular structure that is adapted to the mounting hole 15 on the rear housing 11 and the light-transmitting part 30. Based on this, the movable decorative component 200 in the movable decorative module 20 is an annular structure surrounding the light-transmitting part 30 and the camera module 40. However, it should be noted that the movable decorative component 200 in the movable decorative module 20 includes a first movable decorative component 200a and a decorative component 200b, the first movable decorative component 200a is sleeved over the second movable decorative component 200b, and the second movable decorative component 200b is sleeved over the light-transmitting part 30. In other words, the movable decorative module 20 includes a plurality of movable parts, and each movable part may move independently in a respective direction (for example, a direction d3a and a direction d3b). Based on this, the interactive capability of the mobile phone 1 can be further improved, and user experience can be further enhanced.

For ease of description and understanding, in this application, the central axis in the camera module is defined as a fourth preset axis. In some other embodiments of this application, the first movable decorative component 200a and the second movable decorative component 200b may move, respectively, relative to the fixed decorative component 100 (the rear housing 11, the middle frame 12, the display 13, the light-transmitting part 30, and the camera module 40) in a direction parallel to the fourth preset axis.

FIG. 9(e) shows a relative position relationship between the movable decorative component 200, the light-transmitting part 30, and the camera module 40 in some other embodiments of this application. As can be seen by comparing FIG. 9(e) with FIG. 9(a), in some other embodiments of this application, the camera module 40 includes at least two cameras, and each camera in the camera module 40 corresponds to one light-transmitting part 30 and one movable decorative module 20. For example, in FIG. 9(e), the camera module 40 includes a first camera 41, a second camera 42, a third camera 43, and a fourth camera 44. Based on this, the movable decorative component 200 in the movable decorative module 20 is an annular structure surrounding the light-transmitting part 30 and each camera. For example, the movable decorative component 200 includes a first movable decorative component 200a, a second movable decorative component 200b, a third movable decorative component 200c, a fourth movable decorative component 200d, and a fifth movable decorative component 200e. Each movable decorative component may move relative to the fixed decorative component.

It may be understood that the movable decorative component 200 in FIG. 9(e) corresponds to a camera in the camera module 40, and is unrelated to the outer contour of the camera module 40. Therefore, a specific form of the camera module 40 may not be limited in embodiments of this application. For example, the outer contour of the camera module 40 may be circular, or may be rectangular. This is not specifically limited in this application.

In some embodiments of this application, the central axis of the movable decorative component 200, the central axis of the mounting hole, and the central axis of the light-transmitting part 30 coincide. For ease of description and understanding, in this application, the central axis of the movable decorative component 200, the central axis of the mounting hole, and the central axis of the light-transmitting part 30 that coincide are defined as a fifth preset axis.

In some embodiments of this application, the movable decorative component 200 may rotate around the fifth preset axis along a direction d5 relative to the fixed decorative component 100 (the rear housing 11, the middle frame 12, the display 13, the light-transmitting part 30, and the camera module 40).

In some other embodiments of this application, the movable decorative component 200 may move relative to the fixed decorative component 100 (the rear housing 11, the middle frame 12, the display 13, the light-transmitting part 30, and the camera module 40) in a direction parallel to the fifth preset axis.

It may be understood that the foregoing FIG. 9(a) to FIG. 9(e) are several forms of the decorative module in this application. Other forms or a combination of the foregoing decorative modules are also within the protection scope of this application. This is not specifically limited in this application.

Since the form and distribution of the movable decorative module 20 are described, the following provides a detailed description of a specific structure of the movable decorative module 20 with reference to the accompanying drawings. For ease of understanding and description, the following uses the movable decorative module 20 corresponding to FIG. 9(a) as an example.

FIG. 10 is a diagram of the fixed decorative component 100, the rear housing 11, the light-transmitting part 30, and the camera module 40 according to some embodiments of this application. As shown in FIG. 10, in some embodiments of this application, the movable decorative module 20 includes the fixed decorative component 100 and the movable decorative component 200. The mounting hole 15 is provided in the rear housing 11. The light-transmitting part 30 is sealedly mounted around the mounting hole 15 in the rear housing 11 by using the fixed decorative component 100. The light-transmitting part 30 and the camera module 40 are relatively positioned. The movable decorative component 200 is movably connected to the fixed decorative component 100, and the movable decorative component 200 is at least partially exposed outside the fixed decorative component 100. When the mobile phone is in an assembled state, the fixed decorative component 100 is configured to restrict the movable decorative component 200 from being detached from the fixed decorative component 100, and to enable the movable decorative component 200 to move relative to the fixed decorative component 100 in a preset manner.

Still refer to FIG. 10. In some embodiments of this application, the fixed decorative component 100 includes a first decorative part 110 and a second decorative part 120. The first decorative part 110 is connected to the second decorative part 120, and together form a limiting slot 130. An inner periphery or an outer periphery of the movable decorative component 200 is located in the limiting slot 130, and the fixed decorative component 100 is configured to, via the limiting slot 130, cooperate with the inner periphery or the outer periphery of the movable decorative component 200 to restrict the movable decorative component 200 from being detached from the fixed decorative component 100. In addition, this can ensure that the second decorative part structure 120 rotates around a preset axis relative to the fixed decorative component 100. The preset axis may be, but is not limited to, any one of the first preset axis, the second preset axis, and the third preset axis.

Still refer to FIG. 10. In some implementations, both the first decorative part 110 and the second decorative part 120 are in a ring-shaped trapezoidal structure. In addition, an outer periphery of the first decorative part 110 is connected to the second decorative part 120, forming the limiting slot 130, which is clamped to the inner periphery or the outer periphery of the movable decorative part 200, between the first decorative part 110 and the second decorative part 120.

Still refer to FIG. 10. In some implementations, the first decorative part 110 includes a first portion 111 and a second portion 112. The first portion 111 is in a cylindrical structure, and the second portion 112 is in an annular structure. One end of the first portion 111 is sealedly connected to the outer periphery of the light-transmitting part 30, and the other end of the first portion 111 is sealedly connected to an inner periphery of the second portion 112.

Still refer to FIG. 10. In some implementations, the second decorative part 120 includes a third portion 121, a fourth portion 122, a fifth portion 123, a sixth portion 124, and a seventh portion 125. The third portion 121 is in an annular structure, the fourth portion 122 is in a cylindrical structure, and one end of the fourth portion 122 is connected to an outer periphery of the third portion 121. The fifth portion 123 is in an annular structure, and an inner periphery of the fifth portion 123 is connected to the other end of the fourth portion 122. The sixth portion 124 is in a cylindrical structure, one end of the sixth portion 124 is connected to an outer periphery of the fifth portion 123, and the fourth portion 122 and the sixth portion 124 are sequentially distributed along the first preset axis. The seventh portion 125 is in an annular structure, and an inner periphery of the seventh portion 125 is connected to the other end of the sixth portion 124.

With the specific structures of the first decorative part 110 and the second decorative part 120 as described above, the following describes an assembly relationship between the two. Still refer to FIG. 10. In some implementations, the second decorative part 120 is sleeved over the first decorative part 110, the first portion 111 is located on a side opposite to the third portion 121, and the second portion 112 is located on a side opposite to the seventh portion 125. An outer periphery of the second portion 112 is connected to the fifth portion 123. The third portion 121 and the first portion 111 are disposed opposite to each other, and an inner peripheral surface of the third portion is spaced apart from an outer peripheral surface of the first portion 111. The first portion 111, the second portion 112, the third portion 121, and the fourth portion 122 jointly form the limiting slot 130 that has an opening to an exterior. The other end of the first portion 111 is connected to the light-transmitting part 30. The seventh portion 125 is connected to the rear housing 11.

In the foregoing mobile phone 1, a rational design of the first decorative part 110 and the second decorative part 120 allows for, on one hand, effective control of the movable decorative component 200, so that the fixed decorative component 100 can restrict the movable decorative component 200 from being detached from the fixed decorative component 100, while enabling the movable decorative component 200 to move relative to the fixed decorative component 100 in a preset manner. On the other hand, a connection surface between the light-transmitting part 30 and the first decorative part 110 is parallel to a connection surface between the first decorative part 110 and the second decorative part 120. This ensures similar assembly solutions and consistent load directions during an assembly process, thereby lowering installation difficulty between the light-transmitting part 30, the first decorative part 110, and the second decorative part 120, and improving economic benefits of the mobile phone 1.

It should be noted that there are various manners for connecting the seventh portion 125 to the rear housing 11. The following describes several manners for connecting the seventh portion 125 to the rear housing 11 with reference to the accompanying drawings.

Still refer to FIG. 10. In some implementations, an outer surface of the seventh portion 125 is in close contact with an inner surface around the mounting hole 15 in the rear housing 11. It may be understood that, in this application, that two parts are in close contact means that the two parts are connected to each other and are in complete contact with no gap between them. In some implementations, the two parts may be in close contact in a manner in which the two parts are connected to each other by using a sealant.

In the mobile phone 1, the movable decorative component 200 is in close contact with the inner wall surface 11a of the rear housing 11, preventing the peripheral boundary of the movable decorative component 200 from being exposed externally to the rear housing 11, thereby further improving aesthetic appeal of the mobile phone 1. Additionally, the second portion 112 in the first decorative part 110 is in close contact with the inner surface of the movable decorative component 200, preventing the peripheral boundary of the first decorative part 110 from being exposed externally to the movable decorative component 200, thereby improving aesthetic appeal of the mobile phone 1.

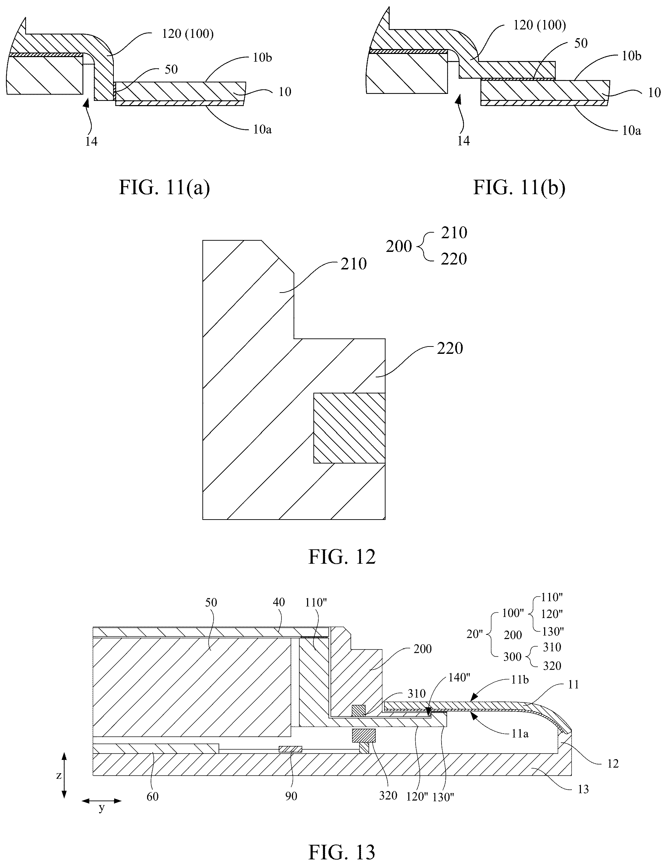

FIG. 11(a) is a partial enlarged view of a region E in FIG. 10 according to some other embodiments of this application. As shown in FIG. 11(a), in some other alternative implementations, an inner surface of the seventh portion 125 is in close contact with an outer surface around the mounting hole 15 in the rear housing 11.

In the mobile phone 1, a periphery of the second decorative part 120 is disposed outside the rear housing 11, lowering assembly difficulty of the second decorative part 120, improving assembly efficiency of the mobile phone 1, and consequently improving economic benefits of the mobile phone 1.

FIG. 11(b) is a partial enlarged view of the region E in FIG. 10 according to some other embodiments of this application. As shown in FIG. 11(b), in some other alternative implementations, an outer peripheral surface of the seventh portion 125 is in close contact with a surface of the mounting hole 15 in the rear housing 11.

It may be understood that FIG. 10, FIG. 11(a), and FIG. 11(b) show a scenario in which the fixed decorative component 100 includes the second decorative part 120, the second decorative part 120 includes the seventh portion 125, and the seventh portion 125 is connected to the rear housing 11. In another application scenario, the fixed decorative component 100 may be in another form. For a specific connection solution between the fixed decorative component 100 and the rear housing 11, refer to the connection manner between the seventh portion 125 and the rear housing 11 shown in FIG. 10, FIG. 11(a), and FIG. 11(b). Details are not described in the following.

In terms of a combination manner between the rear housing 11 and the fixed decorative component 100, still referring to FIG. 10. FIG. 11(a), and FIG. 11(b), it may be learned that in some embodiments of this application, the rear housing 11 and the fixed decorative component 100 may be secured by an adhesive layer 50. In some implementations, the adhesive layer 50 is in an annular structure, and the adhesive layer 50 is disposed around the mounting hole 15 in the rear housing 11. Based on this, the first mounting component 110 is secured to the rear housing 11 by using the adhesive layer 50, and a sealed connection between the movable decorative module 20 and the rear housing 11 may be implemented. It may be understood that adhesive dimensions between the fixed decorative component 100 and the rear housing 11 need to meet a protection requirement of a product. For example, a depth of the adhesive layer 50 (that is, dimensions of the adhesive layer 800 in the xoy plane) needs to meet waterproof and dustproof requirements. Details are not described herein.

With the fixed decorative component 100 in the movable decorative module 20 described above, the following describes the movable decorative component 200 in the movable decorative module 20 in this application with reference to the accompanying drawings.

FIG. 12 is a diagram of the movable decorative component 200 in FIG. 9 according to some embodiments of this application. As shown in FIG. 12, the movable decorative component 200 includes an eighth portion 210 and a ninth portion 220. Both the eighth portion 210 and the ninth portion 220 are in a cylindrical structure. An outer peripheral dimension of the eighth portion 210 is greater than an inner peripheral dimension of the ninth portion 220, and an outer peripheral dimension of the ninth portion 220 is greater than the outer peripheral dimension of the eighth portion 210. The eighth portion 210 and the ninth portion 220 are disposed coaxially in sequence, and an end face of the eighth portion 210 is connected to an end face of the ninth portion 220.

It can be seen from FIG. 8, FIG. 10, and FIG. 12 that the movable decorative component 200 is sleeved over the first portion 111 in the first decorative part 110, and an end face of the ninth portion 220 in the movable decorative component 200 faces the second portion 112. The third portion 121 and the fourth portion 122 in the fixed decorative component 100 are sleeved over the movable decorative component 200. The eighth portion 210 in the movable decorative component 200 is configured to be exposed via the gap between the first portion 111 and the third portion 121. In some implementations, the eighth portion 210 is configured to protrude through the gap between the first portion 111 and the third portion 121. In another alternative implementation, an end face of the eighth portion 210 opposite to the ninth portion 220 is flush with an outer surface of the movable decorative component 200.

It can be seen from FIG. 8, FIG. 10, and FIG. 12 that the outer peripheral surface of the first portion 111 and an inner peripheral surface of the fourth portion 122 restrict movement of the movable decorative component 200 in the xoy plane. Surfaces of the second portion 112 and the third portion 121 that are opposite to each other are configured to restrict movement of the movable decorative component 200 in a z direction. Based on this, the movable decorative component 200 is configured only to rotate around a z-axis (a first axis) relative to the fixed decorative component 100.

The following describes a technical solution of a movable decorative module 20a in some other embodiments with reference to the accompanying drawings. FIG. 13 is a partial enlarged view of a region D in FIG. 7 according to some other embodiments of this application. As shown in FIG. 13, in some embodiments of this application, the movable decorative module 20a includes a fixed decorative component 100" and a movable decorative component 200". It may be learned, by comparing FIG. 13 with FIG. 8, that the movable decorative component 200" shown in FIG. 13 may be the same as the movable decorative component 200 shown in FIG. 8, and details are not described herein again. A difference lies in that a manner of forming a limiting slot (not marked) in the fixed decorative component 100" shown in FIG. 13 is different from a manner of forming a limiting slot (not marked) in the fixed decorative component 100 shown in FIG. 8.

Still refer to FIG. 13. In some embodiments of this application, the fixed decorative component 100" and the rear housing 11 jointly form a limiting slot.

Still refer to FIG. 13. In some implementations, the fixed decorative component 100" includes a first portion 110", a second portion 120", and a third portion 130". The first portion 110", the second portion 120", and the third portion 130" are all in a cylindrical structure. An outer peripheral surface of the first portion 110" is in contact with an inner peripheral surface of the second portion 120", and an outer peripheral surface of the second portion 120" is in contact with an inner peripheral surface of the third portion 130". An end face of the second portion 120" opposite to the display 13 is lower than both an end face of the first portion 110" opposite to the display 13 and an end face of the third portion 130" opposite to the display 13. Based on this, the first portion 110", the second portion 120", and the third portion 130" jointly form an annular groove 140". A groove surface of the annular groove 140" and an inner surface of the rear housing 11 jointly form a limiting slot.

For the mobile phone 1, the movable decorative module 20a has a relatively small quantity of parts, thereby lowering assembly difficulty and design difficulty for a product.

It may be understood that, for the rear housing 11, the middle frame 12, the display 13, the light-transmitting part 30, and the camera module 40 in this application, refer to a common structure in the mobile phone 1. Based on this, with the movable decorative module 20 (or the movable decorative module 20a) in the mobile phone 1 as described above, the following describes other parts in the mobile phone 1 with reference to the accompanying drawings.

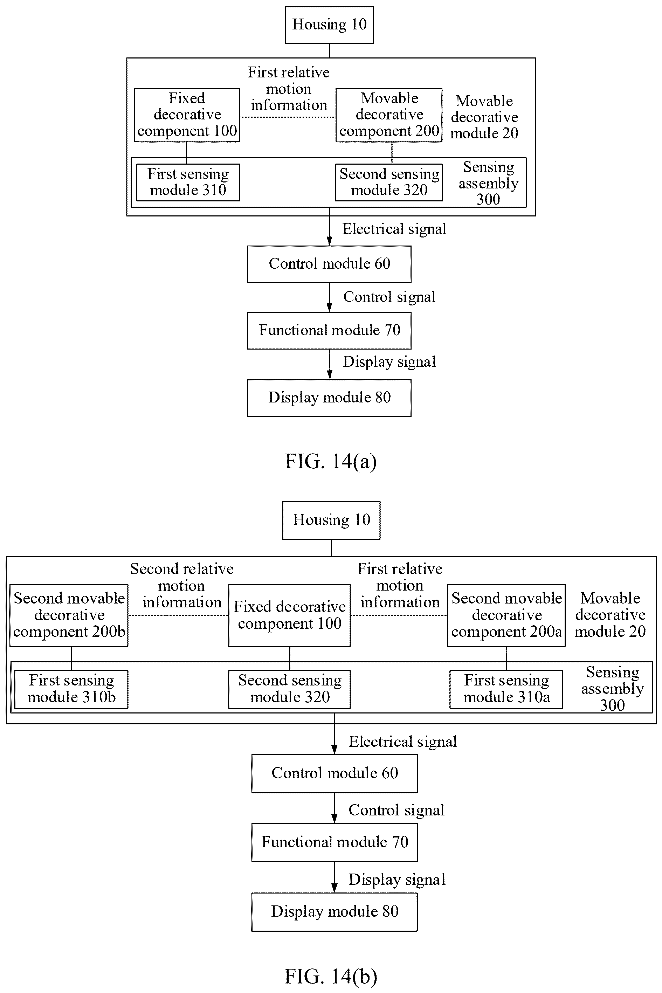

FIG. 14(a) is a modular diagram of a mobile phone 1 according to some embodiments of this application. It can be seen from FIG. 8, FIG. 13, and FIG. 14(a) that, in some embodiments of this application, the mobile phone 1 further includes the sensing assembly 300. The sensing assembly 300 includes the first sensing module 310 and the second sensing module 320. The first sensing module 310 is mounted on the movable decorative component 200, and the second sensing module 320 is located in the cavity 14 and is mounted on the middle frame 12. When the first sensing module 310 and the second sensing module 320 are in a preset state, the second sensing module 320 senses a sensing signal based on the first sensing module 310. In addition, the sensing signal may be configured to control another function of the mobile phone 1 or another electronic device in communication with the mobile phone 1.

Additionally, it can be seen from FIG. 8, FIG. 13, and FIG. 14(a) that, in some embodiments of this application, the mobile phone 1 further includes a control module 60, a functional module 70, and a display module 80. The sensing assembly 300 senses a sensing signal, converts the sensing signal into an electrical signal, and sends the electrical signal to the control module 60. After receiving the electrical signal, the control module 60 generates a control signal (for example, an application switching instruction, a volume adjustment instruction, or the like) according to control logic and processing logic that are stored internally, and sends the generated control signal to the functional module 70. The functional module 70 generates a display signal according to the control signal, and sends the generated display signal to the display module 80. The display module 80 displays content based on the received display signal, thereby changing display effect of the mobile phone 1.

In some implementations, the mobile phone 1 further includes a rectifier module 90. The rectifier module 90 is configured to rectify an electrical signal and then send the rectified electrical signal to the control module 60.

In some embodiments of this application, that the first sensing module 310 and the second sensing module 320 are in the preset state may be that the first sensing module 310 and the second sensing module 320 have a preset relative position. In some implementations, that the first sensing module 310 and the second sensing module 320 have the preset relative position may include a relative direction and a relative distance. The relative direction may be a direction from the first sensing module 310 to the second sensing module 320 in a preset coordinate system. The relative distance refers to an actual distance between the first sensing module 310 and the second sensing module 320. In this application, the relative direction may be a direction or a direction range. The relative distance may be a distance or a distance range. This is not specifically limited in this application.

When the first sensing module 310 and the second sensing module 320 are in the preset relative position, the first sensing module 310 and the second sensing module 320 are in a preset relative direction range, and a distance between the first sensing module 310 and the second sensing module 320 is in a preset distance range.

It may be understood that, in this application, the relative position relationship between the second sensing module 320 and the fixed decorative component 100 may be that the relative position between the second sensing module 320 and the fixed decorative component 100 remains unchanged, where the second sensing module 320 may be mounted in the fixed decorative component 100, the rear housing 11, the light-transmitting part 30, the camera module 40, and another structure in the cavity 14. This is not specifically limited in this application.

FIG. 14(b) is a modular diagram of the mobile phone 1 according to some embodiments of this application. It can be seen from FIG. 8, FIG. 13, and FIG. 14(b) that, in some embodiments of this application, the movable decorative module 20 includes the fixed decorative component 100, a first movable decorative component 200a, and a second movable decorative component 200b. The mobile phone 1 further includes the sensing assembly 300, where the sensing assembly 300 includes a first sensing module 310a, a first sensing module 310b, and the second sensing module 320. The first sensing module 310a is mounted on the first movable decorative component 200a, the first sensing module 310b is mounted on the second movable decorative component 200b, the second sensing module 320 is located in the cavity 14, and is mounted on the middle frame 12. When the first sensing module 310a and the second sensing module 320 are in the preset state, the second sensing module 320 senses a first sensing signal based on the first sensing module 310a. When the first sensing module 310b and the second sensing module 320 are in the preset state, the second sensing module 320 senses a second sensing signal based on the first sensing module 310b. The first sensing signal and the second sensing signal are used to control another function of the mobile phone 1 or the another electronic device in communication with the mobile phone 1.

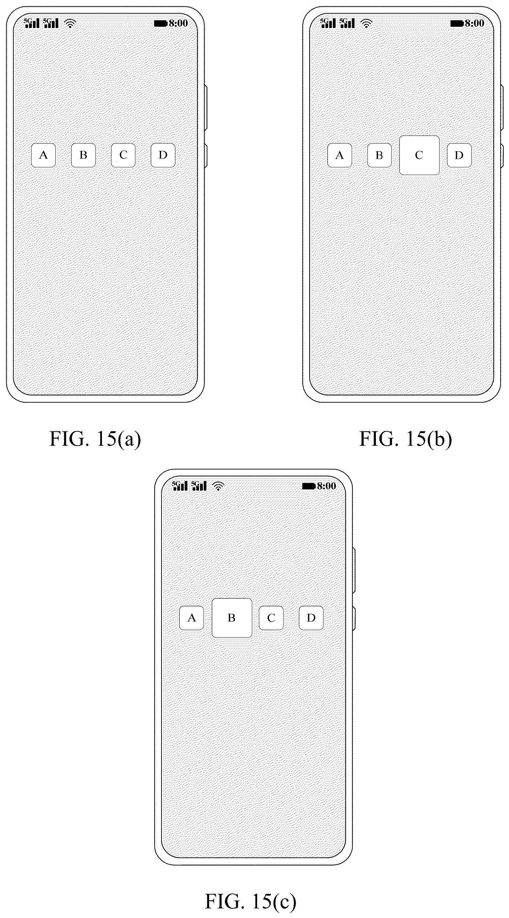

In some embodiments of this application, the mobile phone 1 can switch, based on the sensing signal, an application type currently selected by the mobile phone 1. The following provides descriptions with reference to FIG. 15(a) to FIG. 15(c).

In some implementations, for example, as shown in FIG. 15(a), the application types in the mobile phone 1 may include but are not limited to a music application A, a chat application B, a purchase application C, and a photographing application D. However, after the user selects the purchase application C, for example, as shown in FIG. 15(b), the application C is prominently displayed on the display interface of the mobile phone 1 in an enlarged or highlighted manner. This is not specifically limited in this application. When the second sensing module 320 generates a sensing signal based on the first sensing module 310, the mobile phone 1 switches the currently selected application based on the sensing signal. For example, as shown in FIG. 15(c), the display interface of the mobile phone 1 is switched from highlighting the purchase application C to highlighting the chat application B.

It may be understood that, in some other alternative implementations, the purchase application C highlighted in the display interface of the mobile phone 1 shown in FIG. 15(b) may not be obtained by the mobile phone 1 based on the user's touch on a display 13, but may be obtained by the mobile phone 1 based on the user's operation on the movable decorative component 200. This is not specifically limited in this application.

In some other embodiments of this application, the mobile phone 1 can switch, based on the sensing signal, information currently selected by the mobile phone 1. The information may be an information list in the chat application, or entered information in a text selection area or an emoticon selection area in the chat interface. A display effect of information switching is basically the same as that in FIG. 15(a) to FIG. 15(c), and details are not described herein.

In some other embodiments of this application, the mobile phone 1 can adjust, based on the sensing signal, a value of a corresponding parameter in the application in the mobile phone 1. The corresponding parameter in the application may be any parameter that can be adjusted by the user in the application.

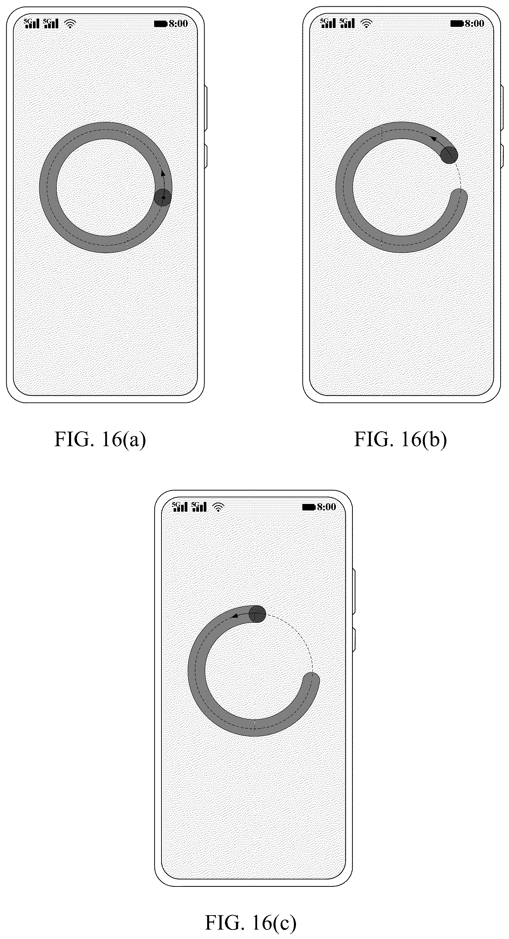

In some implementations, the application is a music application. As shown in FIG. 16(a) to FIG. 16(c), the mobile phone 1 can adjust a volume or a music process in the music application based on the sensing signal, or the mobile phone 1 can switch music played in a list in the music application based on the sensing signal.

In some other alternative implementations, the application is a photographing application, and the mobile phone 1 can adjust light intensity or a size of a variable aperture based on the sensing signal.

In some other embodiments of this application, the mobile phone 1 can adjust, based on the sensing signal, a parameter of an application or an application of an electronic device in communication with the mobile phone 1. The electronic device in communication with the mobile phone 1 may be a terminal device such as a headset or another mobile phone. This is not specifically limited in this application. It may be understood that the mobile phone 1 adjusts the application or the parameter of the application of the another device based on the sensing signal. For details, refer to the foregoing description that the mobile phone 1 adjusts the application or the parameter of the application of the mobile phone 1 based on the sensing signal. Details are not described herein again.

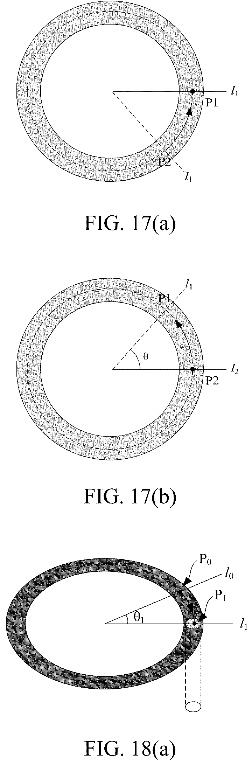

FIG. 17(a) and FIG. 17(b) are working principle diagrams of the first sensing module 310 and the second sensing module 320 according to some embodiments of this application. It can be seen from FIG. 17(a) and FIG. 17(b) that, in some embodiments of this application, the first sensing module 310 forms uneven field strengths (for example, gray areas in FIG. 17(a) and FIG. 17 (b)) that are distributed circumferentially around a preset axis. The second sensing module 320 senses different sensing signals based on each point in the uneven field strengths. In a first state, P1 in the first sensing module 310 is opposite to the second sensing module 320 in terms of position, and in a second state, P2 in the first sensing module 310 is opposite to the second sensing module 320 in terms of position. An included angle θ between l₁ corresponding to a point P1 and l1 corresponding to a point P2 is a rotation angle of the first sensing module 310 relative to the second sensing module.

FIG. 18(a) is a schematic of a relative position relationship between the first sensing module 310 and the second sensing module 320 according to some embodiments of this application. In some implementations, P1 in the first sensing module 310 is opposite to the second sensing module 320. This may be that a projection of P1 in the first sensing module 310 overlaps with a projection of the second sensing module 320 on a preset projection plane (for example, an xoy plane).

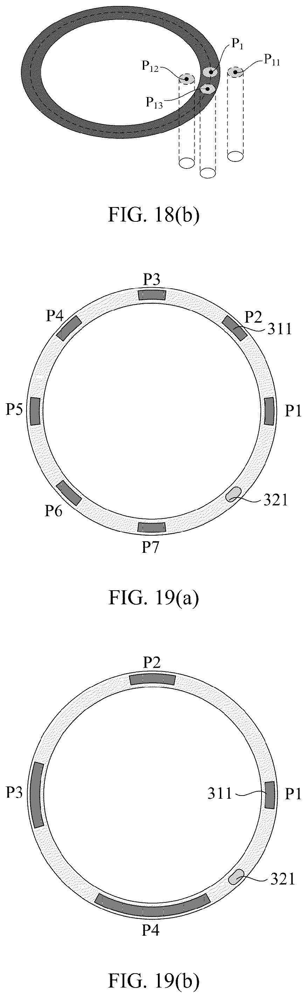

FIG. 18(b) is a schematic of a relative position relationship between the first sensing module 310 and the second sensing module 320 according to some other embodiments of this application. In some other alternative implementations, P1 in the first sensing module 310 is opposite to the second sensing module 320. This may be that a distance between projections of P1 in the first sensing module 310 and the second sensing module 320 on the preset projection plane (for example, an xoy plane) is less than a preset distance threshold. It may be understood that the preset distance threshold may be a critical value that is obtained based on historical data, and at this critical value, the first sensing module 310 and the second sensing module 320 can work normally.

FIG. 19(a) and FIG. 19(b) are diagrams of a structure of the first sensing module 310 according to some embodiments of this application. As shown in FIG. 19(a), in some embodiments of this application, the first sensing module 310 includes a plurality of first sensing parts 311, and each first sensing part 311 has a different field strength. Based on this, each first sensing part 311 and the second sensing module 320 can sense different sensing signals.

For example, there are four, six, or eight first sensing parts 311. The plurality of first sensing parts 311 are arranged circumferentially around a preset axis (for example, the first preset axis, the second preset axis, and the third preset axis). In addition, when the movable decorative component 200 drives the plurality of first sensing parts 311 to rotate, the plurality of first sensing parts 311 may all pass through the second sensing module 320. Each first sensing part 311 has a different field strength. Each first sensing part 311 and the second sensing module 320 can sense different sensing signals.

In some implementations, the plurality of first sensing parts 311 are of the same size, but have different magnetic or electric field strengths. As shown in FIG. 19(a), projection areas of P1, P2, P3, P4, P5, P6, and P7 are the same, but magnetic or electric field strength corresponding to each of P1, P2, P3, P4, P5, P6, and P7 is different.

In some other alternative implementations, the plurality of first sensing parts 311 are of different sizes. As shown in FIG. 19(a), projection areas of P1, P2, P3, and P4 are different, and magnetic or electric field strength corresponding to each first sensing part 311 is adjusted based on different sizes.

In some other embodiments of this application, the second sensing module 320 includes a plurality of second sensing parts 321. For example, there are four second sensing parts 321. The plurality of second sensing parts 321 are arranged circumferentially around a preset axis. In addition, when the movable decorative component 200 drives the first sensing module 310 to rotate, the first sensing module 310 sequentially passes through each second sensing part 321.

In some embodiments of this application, the first sensing module 310 is of magnet structures, and the second sensing module 320 is a magnetometer. For ease of description, a track of the second sensing module 320 moving relative to the first sensing module 310 is defined as a moving track of the second sensing module 320. The magnet structures can form uneven magnetic field strengths in an area through which the moving track of the second sensing module 320 passes.

In some embodiments of this application, the magnet structures form a magnetic field with a circumferential gradient distribution of magnetic field strengths around a central axis. When the movable decorative component 200 moves relative to the fixed decorative component 100, the magnetometer senses a change in a magnetic field strength of a magnetic field, and generates a sensing signal.

In some embodiments of this application, the magnetic intensities of the magnet structures are in a circumferential gradient distribution around the central axis, so that the magnetic field strengths are also in a circumferential gradient distribution around the central axis.

It may be understood that, in this application, the first sensing module 310 may also be designed as a magnetometer, and the second sensing module 320 may be designed as magnet structures. This is not specifically limited in this application.

In some embodiments of this application, the first sensing module 310 is of four magnet structures that are circumferentially arranged on the movable decorative component 200, where each magnet structure has an N pole at one end facing clockwise and an S pole at the other end facing counterclockwise. Based on this, a circular magnetic field around a preset axis is formed. The second sensing module 320 is a magnetometer disposed on the fixed decorative component 100 (or the rear housing 11, the middle frame 12, or the display 13). The magnetometer senses a direction of a magnetic line and a change of magnetic field strength, generates a magnetic signal, and can convert the magnetic signal into an electrical signal. In addition, the magnetometer identifies whether the rotation is clockwise or counterclockwise by identifying the direction change of the magnetic line in the rotation process, and converts the magnetic signal into an electrical signal to adjust the functional module 70 in the mobile phone 1.

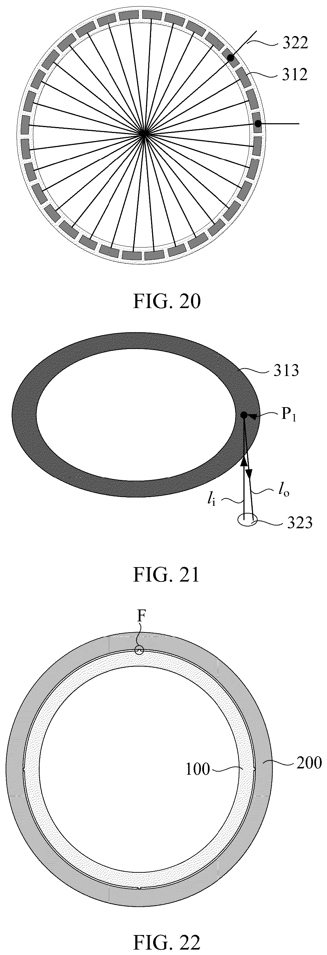

FIG. 20 is a schematic structural diagram of the sensing assembly 300 according to some embodiments of this application. As shown in FIG. 20, in some other embodiments of this application, the sensing assembly 300 is a circuit system disposed on the fixed decorative component 100 and the movable decorative component 200. The first sensing module 310 is a resistor 312 distributed along a radial direction, and the second sensing module 320 is a circuit 322 connected to two ends of the resistor 312. When the movable decorative component 200 rotates relative to the fixed decorative component 100, a resistance value of the resistor 312 in the access circuit 322 can be adjusted, so as to adjust a signal sensed by the sensing assembly 300.

FIG. 21 is a schematic structural diagram of the sensing assembly 300 according to some embodiments of this application. As shown in FIG. 21, in some other embodiments of this application, the sensing assembly 300 is a grating sensor disposed on the fixed decorative component 100 and the movable decorative component 200. The first sensing module 310 is a grating 313 distributed circumferentially around a preset axis, and the second sensing module 320 is a photoelectric element 323. When the movable decorative component 200 rotates relative to the fixed decorative component 100, the photoelectric element 323 emits a beam of light and measures a phase and an amplitude of the reflected light, so as to measure a surface height difference. This helps determine a relative position of the movable decorative component 200 after the movable decorative component 200 rotates relative to the fixed decorative component 100, and further adjust a signal sensed by the sensing assembly 300.

In some embodiments of this application, the grating 313 has a surface with a circumferential gradient distribution of surface roughness around a central axis. When the movable decorative component 200 moves relative to the fixed decorative component 100, the photoelectric element 323 senses a surface roughness change on the surface and generates a sensing signal.

In some embodiments of this application, the grating 313 exhibits a circumferential gradient distribution of surface roughnesses around the central axis.

It may be understood that the first sensing module 310 and the second sensing module 320 are merely some implementations. Other implementations of the first sensing module 310 and the second sensing module 320 that can determine different sensing signals based on different relative positions are also within the protection scope of this application. This is not specifically limited in this application.

It may be understood that the structures of the fixed decorative component 100 and the movable decorative component 200 are merely some implementations of the decorative module in this application. Other forms of the fixed decorative component 100 and the movable decorative component 200 are also within the protection scope of this application. This is not specifically limited in this application.

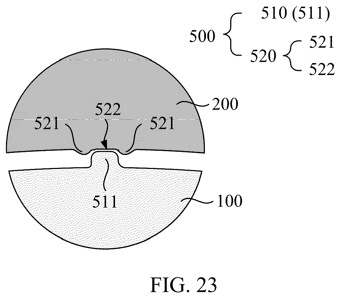

FIG. 22 is a schematic of the fixed decorative component 100 and the movable decorative component 200 according to some embodiments of this application. FIG. 23 is a partial enlarged view of an area F in FIG. 22. It can be seen from FIG. 22 and FIG. 23 that, in some embodiments of this application, in the mobile phone 1, the movable decorative module 20 further includes a limiting assembly 500. The limiting assembly 500 includes a first limiting part 510 and a second limiting part 520. The first limiting part 510 is disposed on the fixed decorative component 100, and the second limiting part 520 is disposed on the movable decorative component 200. When the movable decorative component 200 moves relative to the fixed decorative component 100, the second limiting part 520 cooperates with the first limiting part 510 to restrain the movable decorative component 200 from continuing moving relative to the fixed decorative component 100.

In some implementations, the first limiting part 510 is a first protrusion 511 disposed on a side of the fixed decorative component 100 facing the movable decorative component 200, and the second limiting part 520 is a pair of second protrusions 521 disposed on the movable decorative component 200, where a groove 522 that adapts to the first protrusion 511 is formed between the pair of second protrusions 521. In a locked state, the first protrusion 511 on the fixed decorative component 100 is located in the groove 522 on the movable decorative component 200. In an unlocked state, the first protrusion 511 on the fixed decorative component 100 slides through one of the second protrusions 521, switching from the groove 522 to the outside of the groove 522.

The foregoing describes implementations of this application in specific embodiments, and other advantages and effects of this application may be readily understood by a person skilled in the art from content disclosed in this specification. Although this application is described with reference to some embodiments, it does not mean that a characteristic of this application is limited only to this implementation. On the contrary, a purpose of describing this application with reference to an implementation is to cover another option or modification that may be derived based on claims of this application. To provide an in-depth understanding of this application, the following descriptions include a plurality of specific details. This application may be alternatively implemented without using these details. In addition, to avoid confusion or blurring a focus of this application, some specific details are omitted from the description. It should be noted that embodiments in this application and the features in embodiments may be mutually combined in the case of no conflict.

In the descriptions of this application, it should be noted that unless otherwise explicitly specified and limited, terms such as "dispose", "mount", "connect", and "attach" should be understood in a broad sense. For example, such terms may indicate a fixed connection, a detachable connection, or an integral connection, may indicate a mechanical connection or an electrical connection, and may indicate a direct connection, an indirect connection through an intermediate medium, or internal communication between two elements. A person of ordinary skill in the art may understand a specific meaning of the foregoing term in this application according to a specific situation.

It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. An electronic device, comprising:
a housing;
a movable decorative module, wherein the movable decorative module is at least partially exposed from an outer wall surface of the housing; and
the movable decorative module is at least partially movable relative to the housing, and generates an electrical signal for controlling running of the electronic device.

2. The electronic device according to claim 1, wherein the movable decorative module comprises:
a fixed decorative component, wherein the fixed decorative component is mounted on the housing;
a movable decorative component, wherein the movable decorative component is movably mounted on the fixed decorative component; and
a sensing assembly, wherein the sensing assembly generates, based on motion of the movable decorative component relative to the fixed decorative component, an electrical signal for controlling running of the electronic device.

3. The electronic device according to claim 2, wherein the movable decorative component comprises:
a first movable decorative component, wherein when the first movable decorative component moves relative to the fixed decorative component, the sensing assembly generates a first electrical signal for controlling running of the electronic device.

4. The electronic device according to claim 3, wherein the movable decorative component further comprises:
a second movable decorative component, wherein when the second movable decorative component moves relative to the fixed decorative component, the sensing assembly generates a second electrical signal for controlling running of the electronic device.

5. The electronic device according to any one of claims 2 to 4, wherein the sensing assembly comprises:
a first sensing module, wherein the first sensing module is located on the movable decorative component;
a second sensing module, wherein the second sensing module is located on a side that is of the movable decorative component and that faces away from the fixed decorative component; and
when the movable decorative component is in motion relative to the fixed decorative component, the second sensing module senses, based on the first sensing module, the electrical signal for controlling running of the electronic device.

6. The electronic device according to claim 5, wherein the first sensing module forms a magnetic field with a circumferential gradient distribution of magnetic field strengths around a central axis; when the movable decorative component moves relative to the fixed decorative component, the second sensing module senses a magnetic field strength change of the magnetic field to generate a sensing signal.

7. The electronic device according to claim 6, wherein the first sensing module includes at least two magnet structures that are sequentially arranged in a circumferential direction around the central axis, magnetic poles of each magnet structure point to a consistent circumferential direction around the central axis, and magnetic strengths of the at least two magnet structures are in a circumferential gradient distribution around the central axis; the second sensing module is a magnetometer.

8. The electronic device according to claim 5, wherein the first sensing module has a surface with a circumferential gradient distribution of surface roughnesses around the central axis; when the movable decorative component moves relative to the fixed decorative component, the second sensing module senses a surface roughness change of the surface to generate a sensing signal.

9. The electronic device according to claim 8, wherein the first sensing module includes a grating that is arranged in the circumferential direction around the central axis, wherein surface roughnesses of the grating are in a circumferential gradient distribution around the central axis; the second sensing module is an optoelectronic element.

10. The electronic device according to any one of claims 2 to 9, wherein the housing is provided with a mounting hole that connects the outer wall surface and an inner wall surface, and a fixed decorative component is sealedly connected to the housing around the mounting hole, to seal the mounting hole in the housing.

11. The electronic device according to claim 10, wherein a manner of sealedly connecting the decorative component to the housing includes at least one of the following:
sealedly connecting the decorative component to a surface around the mounting hole on a first side of the housing; or
sealedly connecting the fixed decorative component to a surface around the mounting hole on a second side of the housing; or
sealedly connecting the fixed decorative component to a surface of the mounting hole on the housing.

12. The electronic device according to claim 10 or 11, wherein the mounting hole is a circular hole, and the movable decorative component is rotatively connected to the fixed decorative component around a central axis of the mounting hole.

13. The electronic device according to any one of claims 10 to 12, wherein the electronic device further includes a light-transmitting part, and the light-transmitting part is in a circular shape, wherein the fixed decorative component is of an annular structure, a port at one end of the fixed decorative component is sealedly connected to an outer periphery of the light-transmitting part, and a port at the other end is sealedly connected to the housing around the mounting hole.

14. The electronic device according to claim 13, wherein the movable decorative component is of an annular structure, and the movable decorative component is sleeved between two ends of the fixed decorative component.

15. The electronic device according to any one of claims 2 to 14, wherein the electronic device further includes a control module, wherein the control module is signal-connected to the movable decorative module, and is capable of generating a control signal based on the electrical signal generated by the movable decorative module.

16. The electronic device according to claim 15, wherein the electronic device further includes:
a functional module, wherein the functional module can generate a display signal based on the control signal generated by the control module; and
a display module, wherein the display module is signal-connected to the functional module, and performs display based on a display signal generated by the functional module.

17. The electronic device according to any one of claims 2 to 16, wherein the housing comprises at least one of a display, a middle frame, and a rear housing.

18. The electronic device according to any one of claims 2 to 17, wherein the movable decorative component protrudes at least partially from the outer wall surface of the housing.

19. A housing assembly, comprising:
a housing;
a movable decorative module, wherein the movable decorative module is exposed at least partially from an outer wall surface of the housing; and
the movable decorative module is at least partially movable relative to the outer wall surface of the housing, and generates an electrical signal for controlling running of an electronic device.
